# EUROPEAN PATENT APPLICATION

(11) **EP 1 378 931 A2**
(43) Date of publication of application: **07.01.2004**
(21) Application number: 03009323.1
(22) Date of filing: 24.04.2003
(51) Int. Cl.: H01L 21/00

(54) **Substrate cleaning apparatus and substrate cleaning method**

(30) Priority: 03.07.2002 JP 2002194418
(71) Applicant: Dainippon Screen Mfg., Co., Ltd., Kamigyo-ku Kyoto 602-8585 (JP)
(72) Inventor: Hirae, Sadao, c/o Dainippon Screen MFG. Co., Ltd., Horikawa-dori, Kamigyo-ku, Kyoto602-8585 (JP)
(74) Representative: Goddar, Heinz J., Dr.

(57) **Abstract**

A plurality of substrate holding pins 13 extend upright from a holding stage 12, and a substrate W is mechanically held in a circumferential direction with a back surface Sb of the substrate W faced up. Between the substrate W and the holding stage 12, a drip-proof plate 14 whose shape is approximately the same as that of the substrate W is disposed with a distance from the substrate W in such a manner that the drip-proof plate 14 covers a front surface (pattern-bearing surface) Sf of the substrate W from below. The drip-proof plate 14 disposed so as to cover the front surface Sf of the substrate W blocks the mist from splashing upon the front surface Sf of the substrate.

## Description

### BACKGROUND OF THE INVENTION

### 1. Field of the Invention

The present invention relates to a substrate cleaning apparatus for and a substrate cleaning method of cleaning various types of substrates (hereinafter referred to simply as "substrate(s)"), such as a semiconductor wafer, a glass substrate for photomask, a glass substrate for liquid crystal display, a glass substrate for plasma display and an optical disk substrate.

### 2. Description of the Related Art

At steps for manufacturing semiconductors, manufacturing liquid crystal display apparatuses, etc., a step of cleaning a substrate is indispensable in order to form a pattern through a photolithographic process. Known as an apparatus for cleaning substrates is the substrate cleaning apparatus which is described in Japanese Patent Application Laid-Open Gazette No. H7-86218, for instance. This substrate cleaning apparatus positions a substrate with one major surface of the substrate faced up. The apparatus rubs one major surface of the substrate with a brush while supplying a cleaning liquid applied with ultrasonic vibrations upon one major surface of the substrate, to thereby clean the substrate. Even fine particles, which can not be removed with a brush alone, are removed using a cleaning liquid to which ultrasonic vibrations are applied.

To be more specific, an ultrasonic transducer is disposed to a cleaning nozzle which is for supplying a cleaning liquid upon one major surface of a substrate. The ultrasonic transducer is electrically connected to a high-frequency oscillator. A high radio frequency whose frequency is 1.5 ± 0.3 MHz is applied to the ultrasonic transducer, whereby ultrasonic vibrations are applied to the cleaning liquid. And the vibrated cleaning liquid is injected from the cleaning nozzle toward the substrate.

By the way, there is a problem that during ultrasonic cleaning of one major surface of a substrate as described above, a cleaning liquid splashes as a mist and adheres to the other major surface of the substrate.

When a back surface of a substrate is to be cleaned using a substrate cleaning apparatus which has such a structure above, it is necessary to consider the following problem. That is, a surface bearing a circuit pattern and the like of a substrate among the both major surfaces of the substrate is mainly a surface to be cleaned according to a conventional technique. More and more people have started to recognize that one of causes of a deterioration in yield is particles adhering to a back surface of a substrate during steps for manufacturing electronic components of semiconductors, liquid crystal display apparatuses and like. Therefore, a technique for efficiently removing the particles adhering to the back surface of the substrate is desired. An approach noting this may be to use the substrate cleaning apparatus described above as it is also for the purpose of cleaning back surfaces.

However, a conventional apparatus is set up with a purpose of cleaning and accordingly removing particles which adhere to a substrate front surface having a pattern. Hence, the conventional apparatus can not clean and accordingly remove particles which strongly adhere to a back surface of the substrate. Ultrasonic cleaning permits to enhance the cleaning capability by means of cavitations and improve the cleaning efficiency as the frequency of the ultrasonic cleaning becomes lower. On the contrary, in a conventional apparatus which mainly aims at cleaning a front surface of a substrate, it is necessary to set the frequency of a ultrasonic wave high just to such an extent that the pattern will not be destroyed (For instance, the frequency is set to 1.2 MHz or higher in the conventional apparatus.). Hence, the conventional apparatus suppresses the cleaning capability of ultrasonic cleaning relatively low such that such a pattern destruction will not occur. This results that particles, which adhere to a back surface of a substrate, fail to be efficiently cleaned, and therefore, it is not possible to obtain a sufficient cleaning efficiency.

The frequency of an ultrasonic wave may be set low when only a back surface of a substrate is to be cleaned. However, cleaning in such a condition will lead to a problem that a mist adheres to a front surface of the substrate (pattern-bearing surface) during cleaning of the back surface of the substrate as described above. Meanwhile, if a water film is formed on the front surface of the substrate in an effort to solve this problem, there may arise another problem. It is a problem that the ultrasonic wave applied upon the back surface of the substrate is transmitted by the front surface of the substrate (pattern-bearing surface) and destroys the pattern.

### SUMMARY OF THE INVENTION

A principal object of the present invention is to provide a substrate cleaning apparatus which prevents a mist of a cleaning liquid from adhering to other major surface of a substrate while one major surface of the substrate is cleaned through ultrasonic cleaning, to thereby clean the substrate with a ultrasonic wave at an excellent cleaning efficiency.

Another object of the present invention is to provide a substrate cleaning apparatus and a substrate cleaning method with which it is possible to clean a back surface of a substrate whose front surface bears a pattern at an excellent cleaning efficiency.

To achieve the objects described above, the present invention is directed to a substrate cleaning apparatus for cleaning one major surface of a substrate, comprising: substrate holding means which holds a substrate with one major surface of the substrate faced up; cleaning liquid supplying means which supplies a cleaning liquid at a discharge outlet of a cleaning nozzle onto one major surface of the substrate which is held by the substrate holding means; ultrasonic wave applying means which is disposed on one major surface side of the substrate and applies ultrasonic vibrations upon the cleaning liquid; and drip-proof means which is disposed with a distance from the substrate so as to cover other major surface of the substrate from below.

With such a structure according to the present invention, the cleaning liquid to which ultrasonic vibrations are applied is supplied upon one major surface of the substrate, and ultrasonic cleaning is performed. A mist of the cleaning liquid is created during the cleaning and partially splashes toward the other major surface of the substrate. However, the drip-proof means, disposed to cover the other major surface of the substrate, blocks the mist from splashing upon the other major surface of the substrate and sneaking of the mist.

The drip-proof means is disposed with a distance from the substrate so as to cover the other major surface of the substrate from below. On the account, it is possible to perform ultrasonic cleaning of one major surface of the substrate with a region-in-space (gas layer) created between the other major surface of the substrate and the drip-proof means. As the region-in-space is created adjacent to the other major surface of the substrate, it is possible to dramatically reduce an ultrasonic wave which passes through the other major surface. And therefore, it is not virtually necessary to consider an influence of an ultrasonic wave upon the other major surface and it is possible to increase the freedom with respect to settings regarding the ultrasonic wave. Hence, setting of the frequency of ultrasonic vibrations applied to the cleaning liquid makes it possible to enhance the cleaning capability and improve the cleaning efficiency.

The substrate cleaning method according to the present invention is a method of cleaning a back surface of a substrate whose front surface bears a pattern. In order to achieve another object described above, the method comprises the steps of: disposing a substrate in a condition that the back surface of the substrate is faced up and that a gas layer is adjacent to a front surface of the substrate; and supplying a cleaning liquid upon the back surface of the substrate while ultrasonic vibrations are applied upon the cleaning liquid, to thereby clean the back surface of the substrate with an ultrasonic wave.

Such a structure according to the present invention requires to supply a cleaning liquid upon a back surface of a substrate while applying ultrasonic vibrations upon the cleaning liquid. Since there is a gas layer adjacent to a front surface of the substrate, an ultrasonic wave transmitted by the surface of the substrate is dramatically reduced. This permits to apply ultrasonic vibrations which are suitable to cleaning of the back surface of the substrate upon the cleaning liquid without considering an adverse affect of an ultrasonic wave over the surface of the substrate (pattern-bearing surface) almost at all, and hence, to easily enhance the cleaning efficiency.

The above and further objects and novel features of the invention will more fully appear from the following detailed description when the same is read in connection with the accompanying drawing. It is to be expressly understood, however, that the drawing is for purpose of illustration only and is not intended as a definition of the limits of the invention.

### BRIEF DESCRIPTION OF THE DRAWINGS

Fig. 1 is a drawing which shows the preferred embodiment of the substrate cleaning apparatus according to the present invention;
Fig. 2 is a partially enlarged cross sectional view of the substrate cleaning apparatus of Fig. 1; and
Figs. 3A through 3C are drawings which show the testing method of verifying a relationship between the frequency of the alternating current signal and the sound pressure (ultrasonic cleaning capability) and the result of the experiment.

### DETAILED DESCRIPTION OF THE PREFERRED EMBODIMENTS

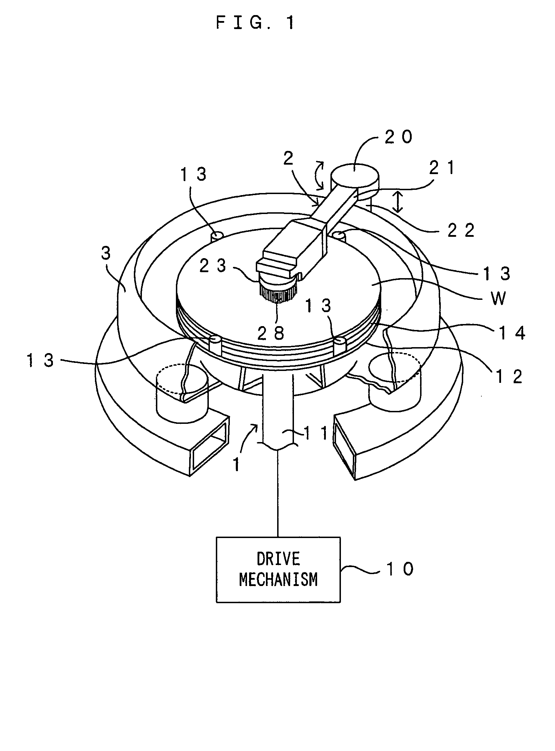

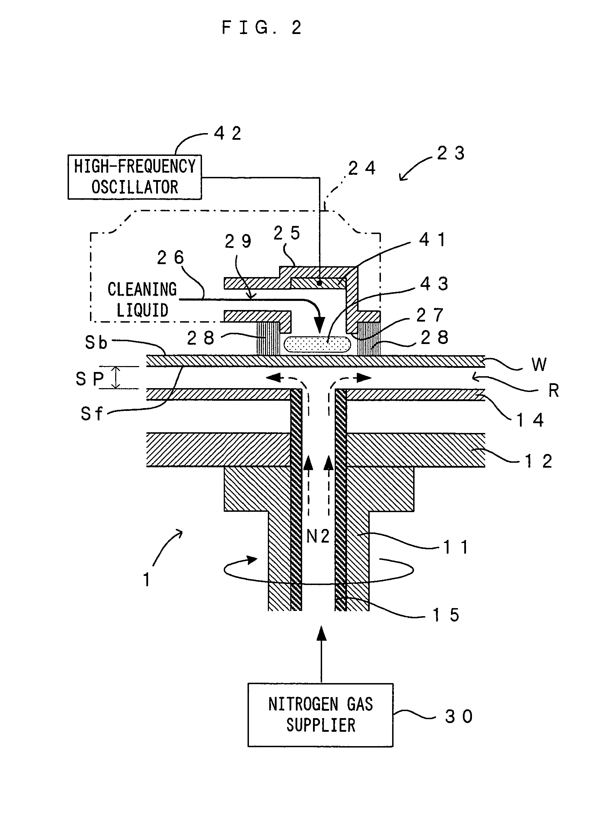

Fig. 1 is a drawing which shows a preferred embodiment of a substrate cleaning apparatus according to the present invention, while Fig. 2 is a partially enlarged cross sectional view of the substrate cleaning apparatus of Fig. 1. This substrate cleaning apparatus is for cleaning and drying a back surface of a substrate W such as a semiconductor wafer. The apparatus comprises: a substrate holding/rotating mechanism 1 which is for rotating the substrate W while holding the substrate W; and a brush cleaning mechanism 2 which slides against the back surface of the substrate W and cleans the back surface of the substrate W. In this preferred embodiment, the "back surface of the substrate" refers to a surface which is on the opposite side to a front surface of a substrate on which a pattern such as an electronic circuit is formed.

The substrate holding/rotating mechanism 1 comprises: a rotation shaft 11 which is driven into rotations by a drive mechanism 10 such as a motor; and a holding stage 12 which is shaped like a disk and whose center is fixed at a top edge of the rotation shaft 11. In this preferred embodiment, the diameter of the holding stage 12 is set to be slightly larger than the diameter of the substrate W. There are a plurality of, four in this preferred embodiment, substrate holding pins 13, disposed to a top surface circumference of the holding stage 12. The pins 13 mechanically hold the substrate W at a circumferential edge portion. This makes it possible to mechanically hold the substrate W in a circumferential direction with the back surface Sb of the substrate W faced up. The plurality of substrate holding pins 13 extending upright from the top surface of the holding stage 12 thus function the "substrate holding means" of the present invention, in this preferred embodiment.

Further, between the holding stage 12 and the substrate W which is held by the plurality of substrate holding pins 13, a drip-proof plate 14 is disposed with a distance from the substrate W. A shape of the drip-proof plate 14 is approximately the same as that of the substrate W. The drip-proof plate 14 covers the front surface (pattern-bearing surface) Sf of the substrate W from below. Hence, as shown in Fig. 2, a region-in-space R is created in a gap space SP between the substrate W and the drip-proof plate 14. The drip-proof plate 14 may be formed by a metal plate, a ceramic plate, a resin plate or the like for instance. An appropriate selection may be made in accordance with the type of a cleaning liquid, etc. The drip-proof plate 14 is received by the plurality of substrate holding pins 13 at the circumferential edge portion of the drip-proof plate 14 and accordingly fixed to the holding stage 12 in this preferred embodiment. A method of fixing the drip-proof plate 14 is not limited to this fixing method but may be any desired method.

The rotation shaft 11 is formed by a hollow shaft, and a pipe 15 is disposed in the hollow portion of the rotation shaft. A top edge of the pipe 15 penetrates the holding stage 12 and is attached to the drip-proof plate 14 through an approximately center portion of the drip-proof plate 14. Further, a bottom edge of the pipe 15 is linked to a nitrogen gas supplier 30. The nitrogen gas supplier 30 may be a utility of a factory where the substrate cleaning apparatus is installed, for instance. Hence, as denoted at the broken-line arrow in Fig. 2, nitrogen gas is supplied from the nitrogen gas supplier 30 through the pipe 15 to the approximately center portion of the region-in-space R, thereby developing a gas flow which moves outward from the region-in-space R. The pipe 15 thus forms the "gas flow generating means" of the present invention, in this preferred embodiment.

In the substrate holding/rotating mechanism 1 having such a structure described above, as the drive mechanism 10 operates, rotations of the rotation shaft 11 rotate the substrate W together with the holding stage 12 and the drip-proof plate 14 as one integrated unit. The drive mechanism 10 thus functions as the "rotating means" of the present invention. In addition, a cup 3 is disposed outside the substrate holding/rotating mechanism 1 in such a manner that the cup 3 covers outer circumferential edges of the holding stage 12, the drip-proof plate 14 and the substrate W from the side toward above. This permits to collect the cleaning liquid which splashes from the back surface Sb of the substrate W as described later.

A structure of the brush cleaning mechanism 2 will now be described. The brush cleaning mechanism 2 comprises an arm 21. A rear end portion of the arm 21 is a base portion and axially supported for free revolutions at a top edge of a column 22 which is disposed outside the cup 3 in such a manner that the column can freely move up and down. As a revolution driver 20 disposed to a top edge portion of the column 22 operates, the front edge of the arm 21 reciprocally whirls in the horizontal direction from the center of the substrate W and a rim, about a link with the column 22. The revolution driver 20 thus functions as the "moving means" of the present invention, and can move a cleaning nozzle which is attached to the front edge of the arm 21 along the substrate W as described below. The column 22 is capable of moving in the vertical direction as described above, and as the columns 22 moves up and down, the arm 21 and the cleaning nozzle can move in the vertical direction as one integrated unit closer to and away from the substrate W.

A cleaning unit 23, which corresponds to the "cleaning liquid supplying means" of the present invention, is disposed to the front edge of the arm 21. In the cleaning unit 23, as shown in Fig. 2, a cleaning nozzle 25 is attached to a lower portion of a front edge of a cleaning body 24. And it is therefore possible to gush out a cleaning liquid 26 such as pure water supplied from a cleaning liquid supply source not shown toward the back surface Sb of the substrate W. Further, a brush 28 is attached to the bottom surface of the cleaning nozzle 25 in such a manner that the brush 28 surrounds a discharge outlet 27 of the cleaning nozzle 25. As the brush 28 slides against the back surface Sb of the substrate W which rotates as described above, the back surface Sb is cleaned. Used as the brush 28 in this preferred embodiment is one implanted with a large number of fibers of a nylon resin or the like.

As shown in Fig. 2, disposed inside the cleaning nozzle 25 is a channel 29 for guiding the cleaning liquid 26 from the cleaning liquid supply source to the discharge outlet 27. An ultrasonic transducer 41 is disposed inside the cleaning nozzle 25 in such a manner that the ultrasonic transducer 41 faces the channel 29. The ultrasonic transducer 41 is electrically connected with a high-frequency oscillator 42. Receiving an alternating current signal outputted from the high-frequency oscillator 42, the ultrasonic transducer 41 vibrates and applies ultrasonic vibrations upon the cleaning liquid 26 which flows through the channel 29 inside the cleaning nozzle 25. As ultrasonic vibrations are applied upon the cleaning liquid 26 in this manner, cavitations are created in a near-surface-area 43 close to the back surface Sb of the substrate W. And an impulse wave develops when the cavitations are crushed. Particles adhering to an area of the back surface facing the near-surface-area 43 are stripped off by the impulse wave thus develops from the substrate W and dispersed within the cleaning liquid. The ultrasonic transducer 41 and the high-frequency oscillator 42 thus function as the "ultrasonic wave applying means" of the present invention which ensures an ultrasonic cleaning effect.

Operations of the substrate cleaning apparatus having such a structure described above will now be described. Although not shown in the drawings, around the substrate cleaning apparatus, there is a cassette in which a number of the substrates W are stacked one atop the other. A substrate transporting robot unloads one substrate at a time and transports the same to the substrate cleaning apparatus. In the substrate cleaning apparatus, the substrate W transported by the substrate transporting robot is positioned by the substrate holding pins 13 with the back surface Sb faced up and mechanically held so as to prevent idling of the substrate. As the substrate transporting robot retracts away from the substrate cleaning apparatus, a control unit not shown controls the respective parts of the apparatus, thereby executing cleaning and drying which will be described in the following.

First, the arm 21 reciprocally whirls in the horizontal direction to a center position of the substrate W, and then moves down to such a position at which a bottom edge of the brush 28 abuts on the back surface Sb of the substrate W. The cleaning liquid is injected at the cleaning nozzle 25 toward the back surface Sb of the substrate W, concurrently with which the high-frequency oscillator 42 applies an alternating current signal upon the ultrasonic transducer 41 and ultrasonic vibrations are accordingly applied upon the cleaning liquid. Cleaning of the back surface Sb of the substrate is initiated in this manner. In this preferred embodiment, the frequency of the alternating current signal mentioned above is set to 400 KHz based on an experiment which will be described later in relation to an example.

The cleaning liquid 26 thus injected at the cleaning nozzle 25 flows upon the substrate W through the discharge outlet 27. Owing to the function of cavitations which are created in the near-surface-area 43, particles adhering to the back surface area receiving the cleaning liquid are stripped off from the back surface Sb of the substrate and dispersed within the cleaning liquid. In this preferred embodiment in particular, since the alternating current signal whose frequency is lower than that used in a conventional apparatus is applied upon the ultrasonic transducer 41 to create cavitations, a stronger cleaning effect is obtained. In addition, the rotation shaft 11 rotates to thereby rotate the substrate W while moving the arm 21 in the horizontal direction in this condition. Hence, the cleaning nozzle 25 moves along the back surface Sb of the substrate and the back surface Sb of the substrate as a whole is accordingly subjected to ultrasonic cleaning.

Further, not only such ultrasonic cleaning but sliding of the brush 28 against the back surface Sb of the substrate as well realize removal of the particles by means of the brush 28 at the same time, which in turn makes it possible to effectively clean and accordingly remove the particles which adhere to the back surface Sb of the substrate. Still further, since brush-based cleaning and ultrasonic cleaning are simultaneously performed by the same arm 21, a cleaning time is shortened as compared to where the ultrasonic cleaning is executed after the brush-based cleaning. Moreover, even when particles adhere to the brush 28 during brush-based cleaning, application of ultrasonic vibrations upon the brush 28 removes the particles from the brush 28 and keeps the brush 28 clean.

After the cleaning finishes, the arm 21 moves slightly up to such a position at which the bottom edge of the brush 28 stays clear of the back surface Sb of the substrate W and the brush-based cleaning is stopped, which is followed by the ultrasonic cleaning alone and rinsing of the back surface Sb of the substrate. As a predetermined period of time elapses, the substrate W is rotated at a high speed with the ultrasonic cleaning, too, stopped and the substrate W is accordingly dried.

After the series of cleaning and drying described above, the substrate transporting robot unloads the substrate W from the substrate cleaning apparatus and houses the substrate W in a different cassette. As all substrates W are thus transferred from the supplying cassette to the receiving cassette, the series of processing completes.

As described above, in this preferred embodiment, the cleaning liquid develops a mist while the cleaning liquid applied with ultrasonic vibrations is supplied upon the back surface Sb of the substrate W and ultrasonic cleaning is executed and the mist partially splashes toward the front surface Sf of the substrate W. However, the drip-proof plate 14 blocks the mist from splashing upon the front surface Sf of the substrate W and effectively prevents sneaking of the mist. Hence, it is possible to clean the substrate in an excellent manner.

In addition, since nitrogen gas is supplied between the substrate W and the drip-proof plate 14, i.e., in the region-in-space R and develops a gas flow which flies outward from the region-in-space R. This results that the gas flow serves as a resistance against splashing of the mist toward the front surface Sf of the substrate and more effectively prevents sneaking of the mist the front surface Sf of the substrate. While this embodiment uses nitrogen gas, it is needless to mention that air, other inert gas or the like may be used instead of nitrogen gas. Further, supplying of gas to the region-in-space R to thereby create a gas flow is not an essential and indispensable element of the present invention but is optional. That is, in the event that the drip-proof plate 14 can sufficiently prevent adhesion of the mist to the front surface Sf of the substrate, the gas supply may be omitted.

It is possible to prevent the mist from adhering to the back surface Sb of the substrate W in this preferred embodiment. Hence, this is particularly effective to substrate processing for which it is desirable that moisture does not adhere to the front surface Sf of the substrate W, e.g., processing for forming a water repellent film or a film which reduces a dielectric constant on the front surface Sf of the substrate for example. Further, adhesion of the mist to the front surface Sf of the substrate is prevented and ultrasonic vibrations are applied upon the cleaning liquid in a condition that the front surface Sf of the substrate is always adjacent to the region-in-space R of the gas layer. On this account, there is less danger that an ultrasonic wave applied upon the back surface Sb of the substrate W will be transmitted by the front surface (pattern-bearing surface) Sf of the substrate and destroy the pattern. In fact, in this preferred embodiment, the frequency of the alternating current signal is set to 400 KHz which is lower than a set value (1.5 MHz ± 0.3) which is used in a conventional apparatus, to thereby enhance the cleaning effect. Still further, with the frequency of the alternating current signal set low, it is possible to stably ensure a high ultrasonic cleaning effect as described in relation to the following example.

The present invention is not limited to the preferred embodiment described above but may be modified to the extent not deviating from the intention of the invention. For instance, while the foregoing has described that gas such as nitrogen gas is supplied to the region-in-space R from the approximately center portion of the drip-proof plate 14 to thereby create a gas flow which flies outward from the region-in-space R, the position for introduction of the gas is not limited to this but may be any desired position at which it is possible to introduce gas to the region-in-space R.

In the preferred embodiment described above, the rotation shaft 11 rotates to thereby rotate the substrate W while moving the arm 21 in the horizontal direction and the cleaning nozzle 25 accordingly moves along the entire back surface Sb of the substrate. An alternative structure may be used that the cleaning nozzle 25 alone scans the entire back surface of the substrate. The alternative structure may be also used that the ultrasonic transducer 41 whose size is the same or larger than the radius of the substrate is fixed in the horizontal direction and the substrate W is rotated relative to the ultrasonic transducer 41.

Further, although the preferred embodiment described above is directed to a substrate cleaning apparatus which cleans the back surface Sb of the substrate, applications of the present invention are not limited to this. The present invention is applicable also to a substrate cleaning apparatus which cleans the front surface Sf of the substrate. In short, the substrate may be held with the front surface Sf of the substrate faced up as "one major surface" of the present invention and the drip-proof plate may be disposed with a distance from the substrate W in such a manner that the drip-proof plate covers the back surface of the substrate which serves as the other major surface of the substrate from below. In this case as well, it is possible to block the mist which develops during cleaning of the front surface of the substrate from partially splashing toward the back surface of the substrate and effectively prevent sneaking of the mist.

An example of the present invention will now be described. The present invention however is not restricted by the following example but may be implemented after modified appropriately to the extent conforming to the intention of the invention. Any such modifications are within the technical scope of the present invention.

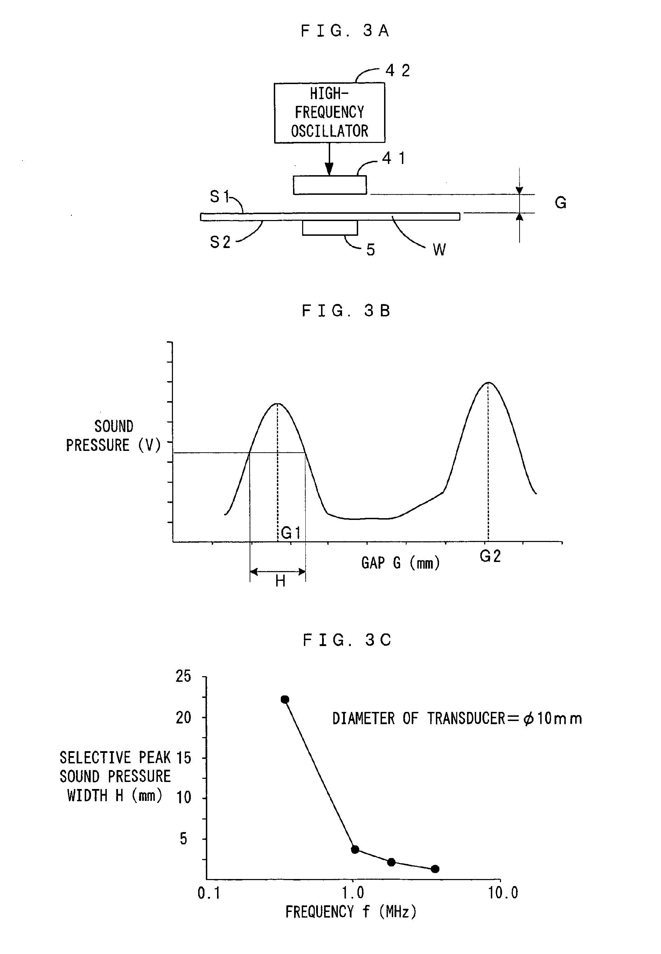

The cleaning capability by means of cavitations improves and the cleaning efficiency becomes better as the frequency of the alternating current signal decreases as described earlier. Further, it was found through various experiments that when a gap G between the ultrasonic transducer 41 and the substrate W changes, the cleaning capability also changes. To be more specific, as shown in Fig. 3A, while changing a space, namely, the gap G between the ultrasonic transducer 41 and one major surface S1 of the substrate W, an alternating current signal whose frequency was 1 MHz was applied from the high-frequency oscillator 42. And with a piezoelectric element 5 bonded to the other major surface S2 of the substrate W, a voltage value corresponding to a sound pressure upon the other major surface S2 of the substrate W was measured. Fig. 3B is a graph which shows one example of the measurement result.

As Fig. 3B clearly shows, a variation in gap G changes the sound pressure. A sound pressure level serves as an index value for the cleaning capability. For the purpose of attaining a high cleaning capability, it is desirable that the gap is set such that the sound pressure level will be ensured. The gap G is therefore preferably set to the gaps G1 and G2 which correspond to sound pressure peaks. While a plurality of sound pressure peaks generally appear, which peak the gap should be set may be determined in accordance with the thickness of the brush and the frequency.

It is necessary to control vertical movements of the column 22 in the substrate cleaning apparatus described above in order to set the gap G to the predetermined gap G1. On the contrary, there is a limitation upon the positioning accuracy for this purpose. It is therefore desired that the sound pressure level is ensured even despite a variation in gap G to a certain extent. In addition, there is a similar demand to that described above, as the optimal gap G1 varies to a certain extent for each apparatus. In other words, it is advantageous to execute substrate cleaning under the condition that a selective peak sound pressure width, e.g., a half width value H is wide. Noting this, for the purpose of verifying a relationship between the frequency of the alternating current signal and the selective peak sound pressure width H, the selective peak sound pressure width H was measured at each frequency while changing the frequency of the alternating current signal among three types of frequency which were 400 KHz, 1 MHz, 1.5 MHz and 3 MHz. Fig. 3C is a graph which shows one example of the measurement result.

As Fig. 3C clearly shows, the selective peak sound pressure width H increases as the frequency of the alternating current signal becomes lower. The curve indicates the change in selective peak sound pressure width H corresponding to the frequency. There is a an inflection point of the curve in the vicinity of 1.2 MHz, which shows that a relatively wide selective peak sound pressure width is obtained as the alternating current signal is set to a lower frequency that this. Hence, when the frequency of the alternating current signal is set to lower than 1.2 MHz, it is possible not only to obtain a higher cleaning capability than that realized by a conventional apparatus but also to widen the selective peak sound pressure width, enhance the tolerance for the gap accuracy and perform stable cleaning. For stabilization of cleaning and the cleaning capability, the frequency of the alternating current signal is preferably set further lower, and more preferably to 400 KHz or lower.

Although the invention has been described with reference to specific embodiments, this description is not meant to be construed in a limiting sense. Various modifications of the disclosed embodiment, as well as other embodiments of the present invention, will become apparent to persons skilled in the art upon reference to the description of the invention. It is therefore contemplated that the appended claims will cover any such modifications or embodiments as fall within the true scope of the invention.

The features disclosed in the foregoing description, in the claims and/or in the accompanying drawings may, both separately and in any combination thereof, be material for realising the invention in diverse forms thereof.

## Claims

1. A substrate cleaning apparatus for cleaning one major surface of a substrate, comprising:
substrate holding means which holds a substrate with one major surface of said substrate faced up;
cleaning liquid supplying means which includes a cleaning nozzle and which supplies a cleaning liquid at a discharge outlet of said cleaning nozzle onto one major surface of said substrate which is held by said substrate holding means;
ultrasonic wave applying means which is disposed on one major surface side of said substrate and applies ultrasonic vibrations upon said cleaning liquid; and
drip-proof means which is disposed with a distance from said substrate so as to cover other major surface of said substrate from below.

2. The substrate cleaning apparatus of claim 1, further comprising a brush which is disposed adjacent to said discharge outlet of said cleaning nozzle and which is capable of rubbing one major surface of said substrate.

3. The substrate cleaning apparatus of claim 2, further comprising moving means which moves said cleaning nozzle relative to one major surface of said substrate.

4. The substrate cleaning apparatus of any one of claims 1 through 3, further comprising rotating means which rotates said substrate and said drip-proof means as one integrated unit.

5. The substrate cleaning apparatus of any one of claims 1 through 3, further comprising gas flow generating means which supplies gas into a region-in-space which is located between said other major surface of said substrate and said drip-proof means, to thereby generate a gas flow which travels outward from said region-in-space.

6. The substrate cleaning apparatus of claim 5, wherein said gas flow generating means supplies gas into said region-in-space from an approximately center portion of said drip-proof means.

7. The substrate cleaning apparatus of any one of claims 1 through 3, wherein said other major surface of said substrate is a front surface of said substrate which bears a predetermined pattern and one major surface of said substrate is a back surface of said substrate which is to be cleaned.

8. The substrate cleaning apparatus of claim 7, wherein said ultrasonic wave applying means comprises: a transducer which is disposed in the vicinity of one major surface of said substrate; and a high-frequency oscillator which applies an alternating current signal whose frequency is lower than 1.2 MHz upon said transducer.

9. The substrate cleaning apparatus of claim 8, wherein said high-frequency oscillator applies an alternating current signal whose frequency is 400 KHz or lower upon said transducer.

10. A substrate cleaning method of cleaning a back surface of a substrate whose front surface bears a pattern, comprising the steps of:
disposing a substrate in a condition that said back surface of said substrate is faced up and that a gas layer is adjacent to a front surface of said substrate; and
supplying a cleaning liquid upon said back surface of said substrate while ultrasonic vibrations are applied upon said cleaning liquid, to thereby clean said back surface of said substrate with an ultrasonic wave.
